# EUROPÄISCHE PATENTSCHRIFT

(11) **EP 1 786 050 B1**
(45) Veröffentlichungstag und Bekanntmachung des Hinweises auf die Patenterteilung: **23.06.2010**
(21) Anmeldenummer: 05024515.8
(22) Anmeldetag: 10.11.2005
(51) Int. Cl.: H01L 51/50

(54) **Dotiertes organisches Halbleitermaterial**
Doped organic semiconductor material
Matériau semiconducteur organique dopé

(43) Veröffentlichungstag der Anmeldung: 16.05.2007
(73) Patentinhaber: Novaled AG, 01307 Dresden (DE)
(72) Erfinder: Werner, Ansgar, 01277 Dresden (DE); Lux, Andrea, 01277 Dresden (DE)
(74) Vertreter: Bittner, Thomas L.

(56) Entgegenhaltungen:
- EP-A- 0 855 848
- EP-A- 1 097 980
- EP-A- 1 511 094
- EP-A2- 0 564 224
- WO-A-03/088271
- WO-A-2005/086251
- GUFENG HE ET AL: "High-efficiency and low-voltage p-i-n electrophosphorescent OLEDs with double-doping emission layers" PROCEEDINGS OF THE SPIE, SPIE, BELLINGHAM, VA, US, Bd. 5464, Nr. 1, 2004, Seiten 26-31, XP002356312 ISSN: 0277-786X

## Beschreibung

Die vorliegende Erfindung betrifft ein dotiertes organisches Halbleitermaterial sowie eine dieses Halbleitermaterial umfassende organische Leuchtdiode (OLED).

Seit der Demonstration von organischen Leuchtdioden und Solarzellen 1989 [C.W. Tang et al., Appl. Phys. Lett. 51 (12), 913 (1987)] sind aus organischen Dünnschichten aufgebaute Bauelemente Gegenstand intensiver Forschung. Derartige Schichten besitzen vorteilhafte Eigenschaften für die genannten Anwendungen, wie z.B. effiziente Elektrolumineszenz für organische Leuchtdioden, hohe Absorptionskoeffizienten im Bereich des sichtbaren Lichtes für organische Solarzellen, preisgünstige Herstellung der Materialien und Fertigung der Bauelemente für einfachste elektronische Schaltungen, u.a. Kommerzielle Bedeutung hat bereits der Einsatz organischer Leuchtdioden für Displayanwendungen.

Die Leistungsmerkmale (opto-)elektronischer mehrschichtiger Bauelemente werden unter anderem von der Fähigkeit der Schichten zum Transport der Ladungsträger bestimmt. Im Falle von Leuchtdioden hängen die ohmschen Verluste in den Ladungstransportschichten beim Betrieb mit der Leitfähigkeit zusammen, was einerseits direkten Einfluss auf die benötigte Betriebsspannung hat, andererseits aber auch die thermische Belastung des Bauelements bestimmt. Weiterhin kommt es in Abhängigkeit von der Ladungsträgerkonzentration der organischen Schichten zu einer Bandverbiegung in der Nähe eines Metallkontakts, die die Injektion von Ladungsträgern erleichtert und damit den Kontaktwiderstand verringern kann. Ähnliche Überlegungen führen auch für organische Solarzellen zu dem Schluss, dass deren Effizienz auch durch die Transporteigenschaften für Ladungsträger bestimmt wird.

Durch Dotierung von Löchertransportschichten mit einem geeigneten Akzeptormaterial (p-Dotierung) bzw. von Elektronentransportschichten mit einem Donatormaterial (n-Dotierung) kann die Ladungsträgerdichte in organischen Festkörpern (und damit die Leitfähigkeit) beträchtlich erhöht werden. Darüber hinaus sind in Analogie zur Erfahrung mit anorganischen Halbleitern Anwendungen zu erwarten, die gerade auf Verwendung von p- und n-dotierten Schichten in einem Bauelement beruhen und anders nicht denkbar wären. In US 5,093,698 ist die Verwendung von dotierten Ladungsträgertransportschichten (p-Dotierung der Löchertransportschicht durch Beimischung von akzeptorartigen Molekülen, n-Dotierung der Elektronentransportschicht durch Beimischung von donatorartigen Molekülen) in organischen Leuchtdioden beschrieben.

Folgende Ansätze sind bisher für die Verbesserung der Leitfähigkeit von organischen aufgedampften Schichten bekannt:
1. Erhöhung der Ladungsträgerbeweglichkeit durch
   a) Verwendung von Elektronentransportschichten bestehend aus organischen Radikalen (US 5,811,833),
   b) Erzeugung hoch geordneter Schichten, die eine optimale Überlappung der pi-Orbitale der Moleküle erlauben,
2. Erhöhung der Dichte der beweglichen Ladungsträger durch
   a) Reinigung und schonende Behandlung der Materialien, um die Ausbildung von Ladungsträgerhaftstellen zu vermeiden,
   b) Dotierung organischer Schichten mittels
      aa) anorganischer Materialien (Alkalimetalle: J. Kido et al., US 6,013,384; J. Kido et al., Appl. Phys. Lett. 73, 2866 (1998), Oxidationsmittel wie Iod, SbCl₅ etc.)
      bb) organische Materialien (TNCQ: M. Maitrot et al., J. Appl. Phys., 60 (7), 2396-2400 (1986), F4TCNQ: M. Pfeiffer et al., Appl. Phys. Lett., 73 (22), 3202 (1998), BEDT-TTF: A. Nollau et al., J. Appl. Phys., 87 (9), 4340 (2000), Naphthalendicarbonsäureamide: M.Thomson et al., WO03088271, kationische Farbstoffe: A.G. Werner, Appl. Phys. Lett. 82, 4495 (2003)
      cc) Organometallverbindungen (Metallocene: M.Thomson et al., WO03088271) dd) Metallkomplexe (Ru⁰(terpy)₃: K. Harada et al., Phys. Rev. Lett. 94, 036601 (2005)

Während es für die p-Dotierung bereits ausreichend starke, organische Dotanden gibt (F4TCNQ), stehen für die n-Dotierung nur anorganische Materialien, zB Cäsium, zur Verfügung. Durch Einsatz dieser konnte auch bereits eine Verbesserung der Leistungsparameter von OLEDs erzielt werden. So erzielt man durch Dotierung der Löchertransportschicht mit dem Akzeptormaterial F4TCNQ eine drastische Reduzierung der Betriebsspannung der Leuchtdiode (X. Zhou et al., Appl. Phys. Lett., 78 (4), 410 (2001).). Ein ähnlicher Erfolg ist durch die Dotierung der elektronen- transportierenden Schicht mit Cs oder Li zu erzielen (J. Kido et al., Appl. Phys. Lett., 73 (20), 2866 (1998); J.-S. Huang et al., Appl. Phys. Lett., 80, 139 (2002)).

Ein großes Problem bei der n-Dotierung war lange Zeit, dass für diese nur anorganische Materialien zur Verfügung standen. Die Verwendung von anorganischen Materialien hat jedoch den Nachteil, dass die verwendeten Atome bzw. Moleküle aufgrund ihrer geringen Größe leicht im Bauelement diffundieren können und somit eine definierte Herstellung z.B. scharfer Übergänge von p- dotierten zu n-dotierten Gebieten erschweren.

Die Diffusion sollte demgegenüber bei Verwendung großer Raum ausfüllender organischer Moleküle als Dotanden eine untergeordnete Rolle spielen, da Platzwechselvorgänge nur unter Überwindung höherer Energiebarrieren möglich sind.

Es ist seit vielen Jahren insbesondere bei organischen polymeren Halbleitermaterialien bekannt, daß ein wirksamer Elektronentransfer von einem Dotanden (beispielsweise Natrium) auf die organische Matrix (beispielsweise Polyacetylen) nur möglich ist, wenn die Differenz zwischen HOMO-Energieniveau (= Ionisationspotential) des Dotanden und dem LUMO-Energieniveau (= Elektronenaffinität) der Matrix möglichst gering ist.

Zur Bestimmung des Ionsiationspotentials ist Ultraviolett-Photoelektronenspektroskopie (UPS) die bevorzugte Methode (z.B. R. Schlaf et al., J. Phys. Chem. B 103, 2984 (1999)). Eine verwandte Methode, inverse Photoelektronenspektroskopie (IPES), wird zur Bestimmung von Elektronenaffinitäten herangezogen (zB. W. Gao et. al, Appl. Phys. Lett. 82, 4815 (2003), ist jedoch weniger etabliert. Alternativ können die Festkörperpotentiale durch elektrochemische Messungen von Oxidationspotentialen Eₒₓ bzw. Reduktionspotentialen E_{red} in der Lösung, z.B. durch Zyklovoltammetrie (engl. Cyclic Voltammetry, CV), abgeschätzt werden (zB. J.D. Anderson, J. Amer. Chem. Soc. 120, 9646 (1998)). Mehrere Arbeiten geben empirische Formeln zur Umrechnung der elektrochemischen Spannungsskala (Oxidationspotentiale) in die physikalische (absolute) Energieskale (Ionisationspotentiale) an, zB. B.W. Andrade et al., Org. Electron. 6, 11 (2005); T.B. Tang, J. Appl. Phys. 59, 5 (1986); V.D. Parker, J. Amer. Chem. Soc. 96, 5656 (1974); L.L. Miller, J. Org. Chem. 37, 916 (1972), Y. Fu et al., J. Amer. Chem. Soc. 127, 7227 (2005). Zwischen Reduktionspotential und Elektronenaffinität ist keine Korrelation bekannt, da sich Elektronenaffinitäten nur schwer messen lassen. Deshalb werden vereinfacht die elektrochemische und die physikalische Energieskale über IP=4.8 eV+ e*Eₒₓ (vs. Ferrocen/Ferrocenium) bzw. EA=4.8eV +e*E_{red} (vs. Ferrocen/Ferrocenium) ineinander umgerechnet wie in B.W. Andrade, Org. Electron. 6, 11 (2005) (siehe dort auch Ref. 25-28) beschrieben. Die Umrechnung von verschiedenen Standardpotentialen bzw. Redoxpaaren wird beispielsweise in A.J. Bard, L.R. Faulkner, "Electrochemical Methods: Fundamentals and Applications", Wiley, 2. Ausgabe 2000 beschrieben.

Aus der obigen Darstellung ergibt sich somit, daß die genaue Ermittlung sämtlicher Energiewerte gegenwärtig nicht möglich ist und die dargestellten Werte lediglich als Richtgrößen aufgefaßt werden können.

Beim n-Dotieren fungiert der Dotand als Elektronendonator und überträgt Elektronen auf eine Matrix, welche sich durch eine genügend hohe Elektronenaffinität auszeichnet. Das heißt die Matrix wird reduziert. Durch den Transfer von Elektronen vom n-Dotanden auf die Matrix wird die Ladungsträgerdichte der Schicht erhöht. Inwieweit ein n-Dotand in der Lage ist, Elektronen an eine geeignete, elektronenaffine Matrix abzugeben und dadurch die Ladungsträgerdichte und damit einhergehend die elektrische Leitfähigkeit zu erhöhen, hängt wiederum von der relativen Lage des HOMOs des n-Dotanden und des LUMOs der Matrix relativ zueinander ab. Wenn das HOMO des n-Dotanden über dem LUMO der elektronenaffinen Matrix liegt, kann ein Elektronentransfer stattfinden. Wenn das HOMO des n-Dotanden unter dem LUMO der elektronenaffinen Matrix liegt, kann ebenfalls ein Elektronentransfer stattfinden, vorausgesetzt, dass das die Energiedifferenz zwischen den beiden Orbitalen ausreichend niedrig ist, um eine gewisse thermische Population des höheren Energieorbitals zu ermöglichen. Je kleiner diese Energiedifferenz ist, desto höher sollte die Leitfähigkeit der resultierenden Schicht sein. Die höchste Leitfähigkeit ist jedoch zu erwarten für den Fall, dass das HOMO-Niveau des n-Dotanden über dem LUMO-Niveau der elektronenaffinen Matrix liegt. Die Leitfähigkeit ist praktisch messbar und ein Maß dafür, wie gut der Elektronenübertrag vom Donor auf den Akzeptor funktioniert, vorausgesetzt, dass die Ladungsträgermobilitäten verschiedener Matrizen vergleichbar sind.

Die Leitfähigkeit einer Dünnschichtprobe wird mit der 2-Punkt-Methode gemessen. Dabei werden auf ein Substrat Kontakte aus einem leitfähigen Material aufgebracht, zB Gold oder Indium-Zinn-Oxid. Danach wird die zu untersuchende Dünnschicht großflächig auf das Substrat aufgebracht, so dass die Kontakte von der Dünnschicht überdeckt werden. Nach Anlegen einer Spannung an die Kontakte wird der dann fließende Strom gemessen. Aus der Geometrie der Kontakte und der Schichtdicke der Probe ergibt sich aus dem so bestimmten Widerstand die Leitfähigkeit des Dünnschichtmaterials. Die 2-Punkt-Methode ist zulässig, wenn der Widerstand der Dünnschicht wesentlich größer ist als der Widerstand der Zuleitungen oder der Kontaktwiderstand. Experimentell wird dies durch einen genügend hohen Kontaktabstand gewährleistet und durch kann die Linearität der Strom-Spannungskennlinie überprüft werden.

Untersuchungen der Erfinder haben gezeigt, daß Metallkomplexdotanden der Struktur IV 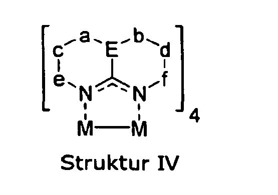 vorteilhaft als Dotanden für ein organisches Matrixmaterial eingesetzt werden können, da ein solcher Dotand das oben beschriebene Diffusionsproblem löst. Aus diesem Grunde wurde ein Dotand mit der Struktur IVa 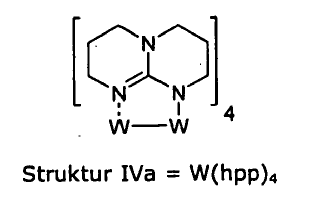 als Dotand für herkömmliche Elektronentransportmaterialien, wie Alq₃ (Tris(8-hydroxy-quinolinato)-aluminium) oder BPhen (4,7-Diphenyl-1,10-phenanthrolin), getestet.

Das Gasphasenionisationspotential des Dotanden mit der Struktur IVa beträgt 3,6 eV. Das entsprechende Ionisationspotential des Festkörpers kann nach Y. Fu et al. (J. Am. Chem. Soc. 2005, 127, 7227-7234) abgeschätzt werden und beträgt etwa 2,5 eV.

Die Ergebnisse sind in der folgenden Tabelle 1 dargestellt.

**Tabelle 1: CV-Daten, empirisch ermittelte LUMO-Energien und gemessene Leitfähigkeiten verschiedener Elektronentransportmaterialien (BAlq₂ = Bis(2-methyl-8-quinolinato)-4-(phenylphenolato)aluminium-(III), BPhen = Bathophenanthrolin, Alq3: (Tris(8-hydroxyquinoline-)aluminium, Cl6-Alq = Tris(5,7-dichloro-8-hydroxyquinoline-)aluminium)**

| Matrixmaterial | LUMO in eV (ermittelt über CV mit Fc/Fc⁺ als internen Standard) | σ (Leitfähigkeit) in S/cm undotiert | σ (Leitfähigkeit) in S/cm bei einer Dotierkonzentration von 5mol% |
|---|---|---|---|
| Alq₃ | 2,4 | < 1E-10 | 9,2E-8 |
| BPhen | 2,42 | < 1E-10 | 4E-9 |
| BAlq₂ | 2.39 | < 1E-10 | 8e-8 |

Wie aus der Tabelle 1 entnommen werden kann, sind die erzielten Leitfähigkeiten mit den bekannten Matrixmaterialien noch unzureichend und sehr gering.

WO 2005/086251 A2 beschreibt die Verwendung eines Metallkomplexes als n-Dotand zur Dotierung eines organischen halbleitenden Matrixmaterials zur Veränderung der elektrischen Eigenschaften desselben. Um n-dotierte organische Halbleiter auch bei Matrixmaterialien mit geringem Reduktionspotential unter Erzielung hoher Leitfähigkeiten bereitzustellen, wird vorgeschlagen, als Dotandenverbindung einen neutralen elektronenreichen Metallkomplex mit einem Zentralatom als vorzugsweise neutrales oder geladenes Übergangsmetallatom mit einer Valenzelektronenzahl von zumindest 16 einzusetzen. Als Matrixmaterial können Phenanthroline eingesetzt werden, die substituiert oder unsubstituiert sein können, wobei Bathophenanthrolin als besonders bevorzugt genannt wird.

G. He et al., Proceedings of the SPIE, SPIE, Bellingham, VA, US, Band 5464, Nr. 1, 2004, Seiten 26-31 beschreiben ein Bathophenanthrolin, das mit Cäsium dotiert ist.

EP 0 564 224 A2 beschreibt eine organische Elektrolumineszenzvorrichtung mit einer Elektronentransportschicht, die aus einem Phenanthrolinderivat besteht.

Aufgabe der vorliegenden Erfindung ist es, ein dotiertes organisches Halbleitermaterial bereitzustellen, das die Nachteile des Standes der Technik überwindet. Insbesondere soll ein Halbleitermaterial zur Verfügung gestellt werden, das eine erhöhte Ladungsträgerdichte und effektive Ladungsträgerbeweglichkeit sowie eine verbesserte

Leitfähigkeit aufweist. Auch soll das Halbleitermaterial eine hohe thermische Stabilität zeigen, die sich beispielsweise aus höheren Glasübergangspunkten, höheren Sublimationstemperaturen und höheren Zersetzungstemperaturen ergibt.

Auch soll eine organische Leuchtdiode bereitgestellt werden, für die das erfindungsgemäße Halbleitermaterial verwendet werden kann.

Die Aufgabe der Erfindung wird gelöst durch ein dotiertes organisches Halbleitermaterial nach Anspruch 1.

Der Dotand kann ein Metallkomplex sein.

Bevorzugt weist der Metallkomplex eine Struktur IV auf: 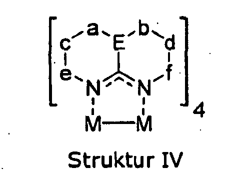 wobei M ein Übergangsmetall ist, vorzugsweise Mo oder W; und wobei
- die Strukturelemente a-f die Bedeutung: a= -CR₉R₁₀-, b = -CR₁₁R₁₂-, c = -CR₁₃R₁₄-, d = R₁₅R₁₆-, e = -CR₁₇R₁₈- und f = -CR₁₉R₂₀- aufweisen können, wobei R₉-R₂₀ unabhängig Wasserstoff, Alkyl mit C₁-C₂₀, Cycloalkyl mit C₁-C₂₀, Alkenyl mit C₁-C₂₀, Alkinyl mit C₁-C₂₀, Aryl, Heteroaryl, -NRR oder -OR sind, wobei R = Alkyl mit C₁-C₂₀, Cycloalkyl mit C₁-C₂₀, Alkenyl mit C₁-C₂₀, Alkinyl mit C₁-C₂₀, Aryl oder Heteroaryl ist, wobei vorzugsweise R₉, R₁₁, R₁₃, R₁₅, R₁₇, R₁₉ = H und R₁₀, R₁₂, R₁₄, R₁₆, R₁₈, R₂₀ = Alkyl mit C₁-C₂₀, Cycloalkyl mit C₁-C₂₀, Alkenyl mit C₁-C₂₀, Alkinyl mit C₁-C₂₀, Aryl, Heteroaryl, -NRR oder -OR ist, oder
- bei den Strukturelementen c und/oder d C durch Si ersetzt sein kann, oder
- wahlweise a oder b oder e oder f NR ist, mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und f oder b und e NR sind, mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, b-d, c-e und d-f, aber nicht gleichzeitig a-c und c-e und nicht gleichzeitig b-d und d-f, ungesättigt sein können,
- wobei die Bindungen a-c, b-d, c-e und d-f Teil eines gesättigten oder ungesättigten Ringsystems sein können, welches auch die Heteroelemente O, S, Se, N, P, Se, Ge, Sn enthalten kann, oder
- die Bindungen a-c, b-d, c-e und d-f Teil eines aromatischen oder kondensierten aromatischen Ringsystems sind, welches auch die Heteroelemente O, S, Si, N enthalten kann,
- wobei das Atom E ein Hauptgruppenelement ist, bevorzugt ausgewählt aus der Gruppe C, N, P, As, Sb
- wobei das Strukturelement a-e-b wahlweise Bestandteil eines gesättigten oder ungesättigten Ringsystems ist, welches auch die Heteroelemente O, S, Se, N, P, Si, Ge, Sn enthalten kann, oder
- das Strukturelement a-E-b wahlweise Bestandteil eines aromatischen Ringsystems ist, welches auch die Heteroelemente O, S, Se, N enthalten kann.

Besonders bevorzugt ist, daß der Dotand die folgende Struktur IVa aufweist:

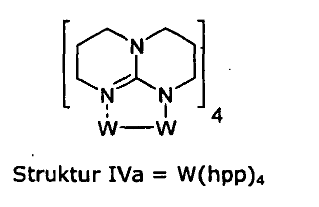

Bevorzugt ist alternativ auch, daß der Dotand ein Alkali- und/oder Erdalkalimetall ist, vorzugsweise Cäsium.

Bevorzugt ist auch, daß die Konzentration des Dotanden 0,5 bis 25 Masseprozent, bevorzugt 1 bis 10 Masseprozent, besonders bevorzugt 2,5 bis 5 Masseprozent beträgt.

Erfindungsgemäß ist auch eine organische Leuchtdiode, welche ein erfindungsgemäßes Halbleitermaterial umfaßt.

Überraschenderweise wurde festgestellt, daß bestimmte Phenanthrolinderivate als Matrixmaterialien eingesetzt werden können, die erforderlich mit Metallkomplexdotanden dotiert werden können. Durch das Einbringen geeigneter Elektronen ziehender Substituenten an bestimmten Positionen im Phenanthrolingerüst lassen sich elektronische Eigenschaften des Halbleitermaterials gezielt einstellen, so daß das LUMO des Phenanthrolinderivats in einen Bereich kommt, der es mit Metallkomplexdotanden, insbesondere mit der Struktur IV, dotierbar macht.

Phenanthrolinderivate sind bislang beispielsweise als undotierte Elektronenleiter (EP 0 564 224 A2) oder Lochblocker (EP 1 097 981, EP 1 097 980) eingesetzt worden. Das Phenanthrolinderivat BPhen ist auch bereits als mit Cäsium dotierte Schicht in organischen Leuchtdioden zum Einsatz gekommen (US 6,013,384), jedoch mit dem eingangs genannten Nachteil der Diffusion des Metalls bei angelegter Spannung, welches zum vorzeitigen Ausfall der Leuchtdiode führt.

Die erfindungsgemäß für das Halbleitermaterial eingesetzten Matrixmaterialien zeigen ferner eine gegenüber dem Stand der Technik verbesserte thermische Stabilität, die insbesondere auf erhöhte Sublimations- und Zersetzungstemperaturen zurückzuführen ist. Auch die Leistungseffizienz einer erfindungsgemäßen OLED ist erhöht.

Weitere Merkmale und Vorteile der Erfindung ergeben sich aus der nachfolgenden detaillierten Beschreibung bevorzugter Ausführungsbeispiele unter Bezug auf beigefügte Zeichnungen, in denen
Figur 1 eine Grafik zeigt, die die Abhängigkeit der Leitfähigkeit von der Temperatur für ein nach Beispiel 2 hergestelltes Halbleitermaterial veranschaulicht;
Figur 2 eine Grafik zeigt, die die Temperaturabhängigkeit der Leitfähigkeit für ein nach Vergleichsbeispiel 2 hergestelltes Halbleitermaterial zeigt; und
Figur 3 eine Grafik zeigt, die die Zeitabhängigkeit der Helligkeit von OLED mit verschiedenen Halbleitermaterialien gemäß der Erfindung und dem Stand der Technik zeigt.

### Beispiel 1

Ausgewählte Phenanthrolinderivate, die in Tabelle 2 unten dargestellt sind, wurden als Matrixmaterial zur Dotierung mit W₂(hpp)₄ (Struktur IVa) eingesetzt und die Leitfähigkeit gemessen. Die Ergebnisse sind in Tabelle 2 aufgeführt.

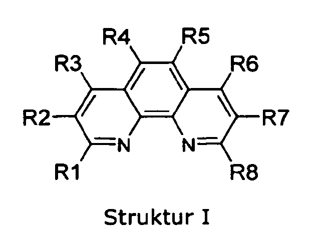

**Tabelle 2:**

| | R | Tg | Ts | LUMO | Leitfähigkeit |
|---|---|---|---|---|---|
| | | (°C) | (°C) | (eV) | (S/cm)* |
| Ia | R2, R4, R5, R7 = H | 106 | 260 | 2,47 | 3E-4 |
| | R1, R3, R6, R8 = phenyl | | | | |
| Ib | R2, R4, R5, R7, R8 = H | 104 | 265 | 2,42 | 5E-6 |
| | R3, R6 = phenyl | | | | |
| | R1 = 1-naphthyl | | | | |
| Ic | R2, R4, R5, R7 = H | 119 | 280 | 2,5 | 2E-6 |
| | R3, R6 = phenyl | | | | |
| | R1, R8 = 1-naphthyl | | | | |
| Id | R2, R4, R5, R7 = H | 140 | 317 | 2,53 | 6E-5 |
| | R3, R6 = phenyl | | | | |
| | R1, R8 = 1-(4,4'-biphenylyl) | | | | |
| Ie | R2, R4, R5, R7 = H | 165 | 317 | 2,51 | 2E-6 |
| | R3, R6 = phenyl | | | | |
| | R1, R8 = 1-phenanthryl | | | | |

| | | | | | |
|---|---|---|---|---|---|
| * Konzentration IVa (W₂(hpp)₄: 5mol% | | | | | |

Ein Vergleich mit den Leitfähigkeitswerten für die aus dem Stand der Technik bekannten Matrixmaterialien Alq₃ und BPhen (Tabelle 1) zeigen für die erfindungsgemäß eingesetzten Phenanthrolinderivate deutlich verbesserte Leitfähigkeitswerte.

### Beispiel 2

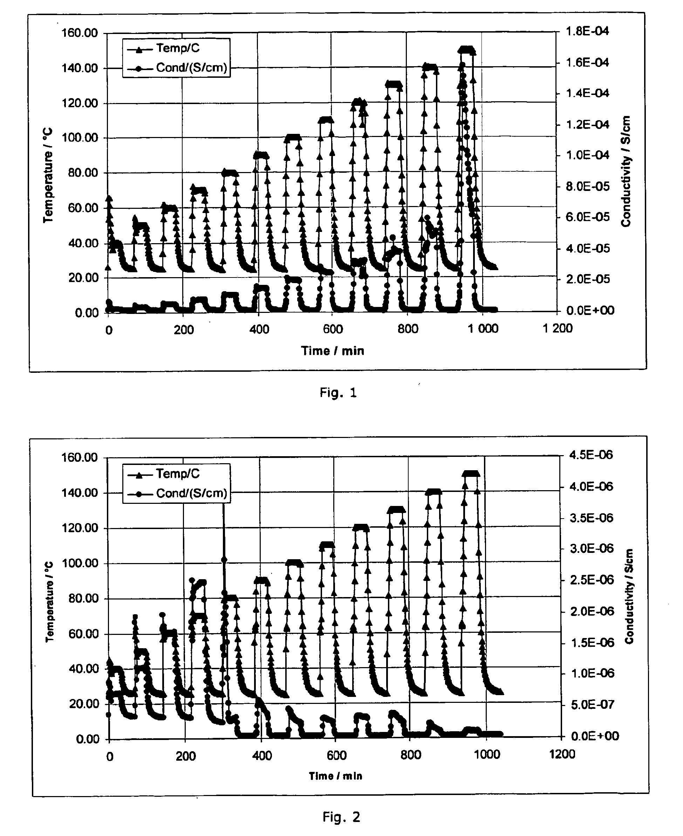

Ein Glassubstrat wird mit Kontakten aus Indium-Zinn-Oxid versehen. Auf das Substrat wird danach eine Schicht aus Ie (Tabelle 2) dotiert mit einem Dotand der Struktur IVa hergestellt. Die Dotierkonzentration des Dotanden IVa beträgt 4mol%. Die Leitfähigkeit der Schicht beträgt 2*10⁻⁶ S/cm bei Raumtemperatur. Anschließend wird die Probe einem Temperaturzyklus unterworfen. Der Temperaturzyklus besteht aus einzelnen Schritten. In jedem Schritt wird die Probe auf die Zieltemperatur geheizt, 20min bei der Zieltemperatur gehalten und dann auf Raumtemperatur abgekühlt. Aufeinanderfolgende Schritte unterscheiden sich dadurch, dass die Zieltemperatur jeweils um 10°C erhöht wird. Während des Temperaturzyklus wird die Leitfähigkeit der Schicht gemessen. Die Ergebnisse sind in Figur 1 gezeigt. Es wird festgestellt, dass die Leitfähigkeit der Mischschicht aus Ie und IVa bis 140°C temperaturstabil ist. Erst bei 150°C fällt die Leitfähigkeit während der 20-minütigen Haltezeit deutlich ab.

### Vergleichsbeispiel 2

Ein Vergleichsbeispiel 2 wurde analog zur Vorgehensweise nach Beispiel 2 durchgeführt, jedoch wurde anstelle des Matrixmaterials Ie BPhen verwendet. Die erhaltene Leitfähigkeit der Schicht beträgt 4*10⁻⁷ S/cm. Wie sich aus Figur 2 ergibt, ist ein solches Halbleitermaterial nur bis zu einer Temperatur von 70°C stabil.

Aus einem Vergleich der Figuren 1 und 2 ergibt sich, daß die Leitfähigkeit eines Halbleitermaterials aus IVa:BPhen zu gering für eine Anwendung für organische Leuchtdioden ist. Bei Verwendung des Matrixmaterials Ie ist die Leitfähigkeit um einen Faktor 5 erhöht, die Temperaturstabilität um 70°C höher.

### Beispiel 3

Ein Substrat aus Glas wird mit Indium-Zinn-Oxid-Kontakten versehen. Darauf werden dann nacheinander die Schichten Spiro-TTB dotiert mit p-Dotand 2-(6-Dicyanomethylene-1,3,4,5,7,8-hexafluoro-6H-naphthalen-2-yliden)-malononitril (50nm, 4mol%), 2,2',7,7'-Tetrakis-(N,N'-diphenylamino)-9,9'-spirobifluoren, N,N'-Di(naphthalen-2-yl)-N,N'-diphenylbenzidin dotiert mit Emitterdotand Iridium(III)bis(2-methyldibenzo-[f,h]quinoxalin)(acetylacetonat) (20nm, 10wt%), Id (10nm), Id dotiert mit IVa (60nm, 4mol%)/ Al (100nm) abgeschieden. Die so hergestellte organische Leuchtdiode emittiert orangerotes Licht.

Die organische Leuchtdiode (OLED) wird einem Stabilitätstest unterzogen. Dabei wird die OLED verkapselt und bei 80°C in einem Ofen betrieben. Die zeitliche Abnahme der Helligkeit bei konstant gehaltener Stromdichte wird gemessen.

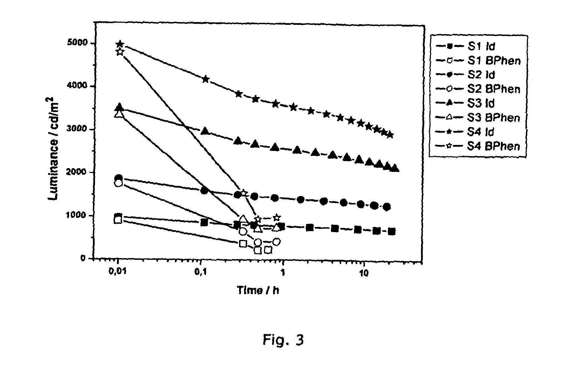

Nach 10 Stunden weist die OLED eine Abnahme der Leuchtdichte von beispielsweise 5000 cd/m2 auf 3300 cd/m2 auf, wie sich aus den ausgefüllten Symbolen gemäß Figur 3 ergibt. Die Abnahme der Leuchtdichte von OLEDs gleicher Struktur bei geringeren Starthelligkeiten wird durch die drei weiteren Kurven mit ausgefüllten Symbolen in Fig. 3 angegeben. Die offenen Symbole stellen die Stabilität der OLED gemäß Vergleichsbeispiel 3 dar.

### Vergleichsbeispiel 3

Eine OLED wurde wie in Beispiel 3 gefertigt, jedoch wurde anstelle von Id BPhen verwendet. Die Abnahme der Leuchtdichte für diese OLED bei kontinuierlichem Betrieb ist ebenfalls in Fig. 3 durch offene Symbole dargestellt. Nach weniger als einer Stunde ist die Helligkeit von 4800 cd/m2 auf unter 1000 cd/m2 abgesunken. Die Wahl von ähnlichen Starthelligkeiten für OLED nach der Struktur von Vergleichsbeispiel 3 bzw. Beispiel 3 erlaubt den direkten Vergleich der Stabilität beider Strukturen. Mithin ist die OLED mit Verwendung von Id als Matrixmaterial stabiler als mit dotiertem BPhen.

## Patentansprüche

1. Dotiertes organisches Halbleitermaterial umfassend mindestens ein organisches Matrixmaterial, das mit mindestens einem Dotanden dotiert ist, wobei das Matrixmaterial ausgewählt ist aus der Gruppe bestehend aus Phenanthrolin-Derivaten der folgenden Struktur I: 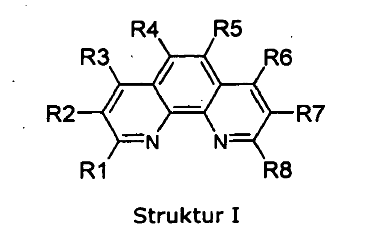 **dadurch gekennzeichnet, dass**
R3 und R6 Aryl sind; R₂, R₄, R₅ und R₇ Wasserstoff sind und zumindest einer der Reste R₁ und R₈ Aryl ist.

2. Halbleitermaterial nach Anspruch 1, **dadurch gekennzeichnet daß** der Dotand ein Metallkomplex ist.

3. Halbleitermaterial nach Anspruch 2, **dadurch gekennzeichnet, daß** der Metallkomplex eine Struktur IV aufweist: 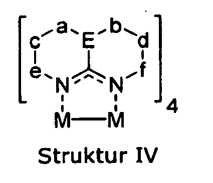 wobei M ein Übergangsmetall ist, vorzugsweise Mo oder W; und wobei
- die Strukturelemente a-f die Bedeutung: a= -CR₉R₁₀-, b = -CR₁₁R₁₂-, c = -CR₁₃R₁₄-, d = R₁₅R₁₆-, e = -CR₁₇R₁₈- und f = -CR₁₉R₂₀- aufweisen können, wobei R₉-R₂₀ unabhängig Wasserstoff, Alkyl mit C₁-C₂₀, Cycloalkyl mit C₁-C₂₀, Alkenyl mit C₁-C₂₀, Alkinyl mit C₁-C₂₀, Aryl, Heteroaryl, -NRR oder -OR sind, wobei R = Alkyl mit C₁-C₂₀, Cycloalkyl mit C₁-C₂₀, Alkenyl mit C₁-C₂₀, Alkinyl mit C₁-C₂₀, Aryl oder Heteroaryl ist, wobei vorzugsweise R₉, R₁₁, R₁₃, R₁₅, R₁₇, R₁₉ = H und R₁₀, R₁₂, R₁₄, R₁₆, R₁₈, R₂₀ = Alkyl mit C₁-C₂₀, Cycloalkyl mit C₁-C₂₀, Alkenyl mit C₁-C₂₀, Alkinyl mit C₁-C₂₀, Aryl, Heteroaryl, -NRR oder -OR ist, oder
- bei den Strukturelementen c und/oder d C durch Si ersetzt sein kann, oder
- wahlweise a oder b oder e oder f NR ist, mit R = Alkyl mit C₁-C₂₀, Cycloalkyl mit C₁-C₂₀, Alkenyl mit C₁-C₂₀, Alkinyl mit C₁-C₂₀, Aryl, Heteroaryl, oder
- wahlweise a und f oder b und e NR sind, mit R = Alkyl mit C₁-C₂₀, Cycloalkyl mit C₁-C₂₀, Alkenyl mit C₁-C₂₀, Alkinyl mit C₁-C₂₀, Aryl, Heteroaryl,
- wobei die Bindungen a-c, b-d, c-e und d-f, aber nicht gleichzeitig a-c und c-e und nicht gleichzeitig b-d und d-f, ungesättigt sein können,
- wobei die Bindungen a-c, b-d, c-e und d-f Teil eines gesättigten oder ungesättigten Ringsystems sein können, welches auch die Heteroelemente O, S, Se, N, P, Se, Ge, Sn enthalten kann, oder
- die Bindungen a-c, b-d, c-e und d-f Teil eines aromatischen oder kondensierten aromatischen Ringsystems sind, welches auch die Heteroelemente O, S, Si, N enthalten kann,
- wobei das Atom E ein Hauptgruppenelement ist, bevorzugt ausgewählt aus der Gruppe C, N, P, As, Sb,
- wobei das Strukturelement a-E-b wahlweise Bestandteil eines gesättigten oder ungesättigen Ringsystems ist, welches auch die Heteroelemente O, S, Se, N, P, Si, Ge, Sn enthalten kann, oder
- das Strukturelement a-E-b wahlweise Bestandteil eines aromatischen Ringsystems ist, welches auch die Heteroelemente O, S, Se, N enthalten kann.

4. Halbleitermaterial nach Anspruch 3, **dadurch gekennzeichnet, dass** der Dotand die folgende Struktur IVa aufweist:

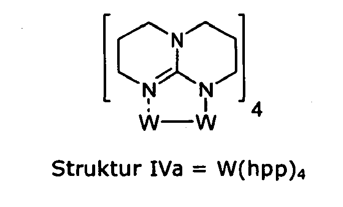

5. Halbleitermaterial nach Anspruch 1, **dadurch gekennzeichnet, daß** der Dotand ein Alkali- und/oder Erdalkalimetall ist, vorzugsweise Cäsium.

6. . Halbleitermaterial nach einem der vorangehenden Ansprüche, **dadurch gekennzeichnet, dass** die Konzentration des Dotanden 0,5 bis 25 Masseprozent, bevorzugt 1 bis 10 Masseprozent, besonders bevorzugt 2,5 bis 5 Masseprozent beträgt.

7. Organische Leuchtdiode, welche ein Halbleitermaterial nach einem der vorangehenden Ansprüche umfaßt.

## Claims

1. Doped organic semiconductor material comprising at least one organic matrix material, which is doped with at least one dopant, the matrix material being selected from the group consisting of phenanthroline derivatives of the following structure I: 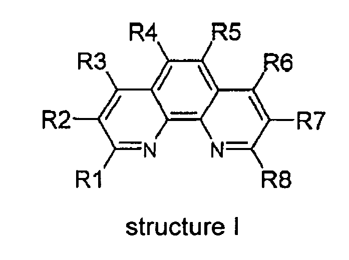 wherein:
R3 and R6 are aryl; R2, R4, R5 and R7 are hydrogen and at least one of R1 and R8 is aryl.

2. Semiconductor material according to claim 1, **characterized in that** the dopant is a metal complex.

3. Semiconductor material according to Claim 2, **characterized in that** the metal complex has a structure IV: 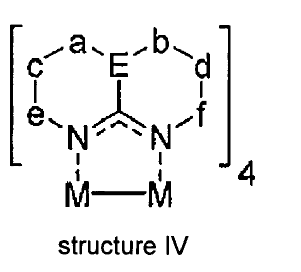 wherein M is a transition metal, preferably Mo or W; and wherein
- the structural elements a-f can have the following meaning: a = -CR₉R₁₀-, b = -CR₁₁R₁₂-, c = -CR₁₃R₁₄-, d = R₁₅R₁₆-, e = -CR₁₇R₁₈- and f = -CR₁₉R₂₀-, wherein R₉-R₂₀ independently of one another are hydrogen, C₁-C₂₀ alkyl, C₁-C₂₀ cycloalkyl, C₁-C₂₀ alkenyl, C₁-C₂₀ alkynyl, aryl, heteroaryl, -NRR or -OR, wherein R = C₁-C₂₀ alkyl, C₁-C₂₀ cycloalkyl, C₁-C₂₀ alkenyl, C₁-C₂₀ alkynyl, aryl or heteroaryl, wherein preferably R₉, R₁₁, R₁₃, R₁₅, R₁₇, R₁₉ = H and R₁₀, R₁₂, R₁₄, R₁₆, R₁₈, R₂₀ = C₁-C₂₀ alkyl, C₁-C₂₀ cycloalkyl, C₁-C₂₀ alkenyl, C₁-C₂₀ alkynyl, aryl, heteroaryl, -NRR or -OR, or
- in the case of structural elements c and/or d, C can be replaced by Si, or
- optionally a or b or e or f is NR, with R = C₁-C₂₀ alkyl, C₁-C₂₀ cycloalkyl, C₁-C₂₀ alkenyl, C₁-C₂₀ alkynyl, aryl, heteroaryl, or
- optionally a and f or b and e are NR, with R = C₁-C₂₀ alkyl, C₁-C₂₀ cycloalkyl, C₁-C₂₀ alkenyl, C₁-C₂₀ alkynyl, aryl, heteroaryl,
- wherein the bonds a-c, b-d, c-e and d-f, but not simultaneously a-c and c-e and not simultaneously b-d and d-f, may be unsaturated,
- wherein the bonds a-c, b-d, c-e and d-f may be part of a saturated or unsaturated ring system, which may also contain the heteroelements O, S, Se, N, P, Se, Ge, Sn, or
- the bonds a-c, b-d, c-e and d-f are part of an aromatic or condensed aromatic ring system, which may also contain the heteroelements O, S, Si, N,
- wherein the atom E is a main group element, preferably selected from the group C, N, P, As, Sb,
- wherein the structural element a-E-b is optionally part of a saturated or unsaturated ring system, which may also contain the heteroelements O, S, Se, N, P, Si, Ge, Sn, or
- the structural element a-E-b is optionally part of an aromatic ring system, which may also contain the heteroelements O, S, Se, N.

4. Semiconductor material according to Claim 3, **characterized in that** the dopant has the following structure IVa:

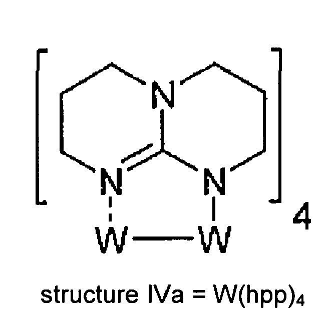

5. Semiconductor material according to Claim 1, **characterized in that** the dopant is an alkali metal and/or alkaline earth metal, preferably caesium.

6. Semiconductor material according to any one of the preceding claims, **characterized in that** the concentration of the dopant is 0.5 to 25 percent by mass, preferably 1 to 10 percent by mass, particularly preferably 2.5 to 5 percent by mass.

7. Organic light-emitting diode, which comprises a semiconductor material according to any one of the preceding claims.

## Revendications

1. Matériau semi-conducteur organique dopé, comprenant au moins un matériau de matrice organique qui est dopé avec au moins un dopant, le matériau de matrice étant sélectionné du groupe constitué de dérivés de phénanthroline de la structure I suivante : 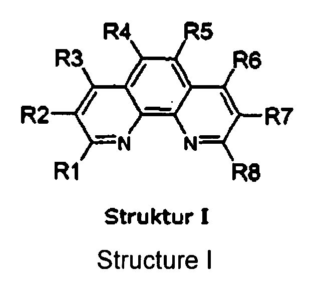 **caractérisé en ce que**
R₃ et R₆ sont l'aryle ; R₂, R₄, R₅ et R₇ sont l'hydrogène et au moins un des restes R₁ et R₈ est l'aryle.

2. Matériau semi-conducteur selon la revendication 1, **caractérisé en ce que** le dopant est un complexe métallique.

3. Matériau semi-conducteur selon la revendication 2, **caractérisé en ce que** le complexe métallique présente une structure IV : 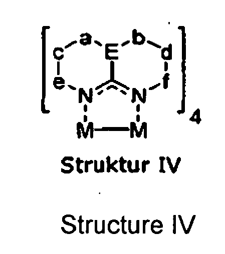 où M est un métal transitoire, de préférence Mo ou W ; et où
- les éléments structurels a-f peuvent avoir la signification suivante : a = - CR₉R₁₀-, b = -CR₁₁R₁₂-, c = -CR₁₃R₁₄-, d = R₁₅R₁₆-, e = -CR₁₇R₁₈- et f = - CR₁₉R₂₀-, où R₉-R₂₀ sont indépendamment l'hydrogène, l'alkyle avec C₁-C₂₀, le cycloalkyle avec C₁-C₂₀, l'alkényle avec C₁-C₂₀, l'alkinyle avec C₁-C₂₀, l'aryle, l'hétéroaryle, -NRR ou -OR, où R = alkyle avec C₁-C₂₀, cycloalkyle avec C₁-C₂₀, alkényle avec C₁-C₂₀, alkinyle avec C₁-C₂₀, aryle ou hétéroaryle, où de préférence R₉, R₁₁, R₁₃, R₁₅, R₁₇, R₁₉ = H et R₁₀, R₁₂, R₁₄, R₁₆, R₁₈, R₂₀ = alkyle avec C₁-C₂₀, cycloalkyle avec C₁-C₂₀, alkényle avec C₁-C₂₀, alkinyle avec C₁-C₂₀, aryle, hétéroaryle, -NRR ou -OR, ou
- chez les éléments structurels c et/ou d, C peut être remplacé par Si, ou
- au choix a ou b ou e ou f est NR, avec R = alkyle avec C₁-C₂₀, cycloalkyle avec C₁-C₂₀, alkényle avec C₁-C₂₀, alkinyle avec C₁-C₂₀, aryle, hétéroaryle, ou
- au choix a et f ou b et e sont NR, avec R = alkyle avec C₁-C₂₀, cycloalkyle avec C₁-C₂₀, alkényle avec C₁-C₂₀, alkinyle avec C₁-C₂₀, aryle, hétéroaryle,
- les liaisons a-c, b-d, c-e et d-f, mais pas simultanément a-c et c-e et pas simultanément b-d et d-f pouvant être non saturées,
- les liaisons a-c, b-d, c-e et d-f pouvant faire partie d'un système annulaire saturé ou non saturé qui peut également contenir les hétéroéléments O, S, Se, N, P, Si, Ge, Sn, ou
- les liaisons a-c, b-d, c-e et d-f font partie d'un système annulaire aromatique ou aromatique condensé qui peut également contenir les hétéroéléments O, S, Si, N,
- l'atome E étant un élément de groupe principal, sélectionné de préférence dans le groupe C, N, P, As, Sb,
- L'élément structurel a-E-b étant au choix partie intégrante d'un système annulaire saturé ou non saturé qui peut également contenir les hétéroéléments O, S, Se, N, P, Si, Ge, Sn, ou
- l'élément structurel a-E-b étant au choix partie intégrante d'un système annulaire aromatique qui peut également contenir les hétéroéléments O, S, Se, N.

4. Matériau semi-conducteur selon la revendication 3, **caractérisé en ce que** le dopant présente la structure Iva suivante :

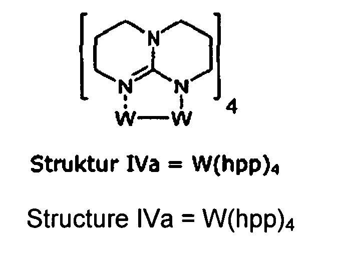

5. Matériau semi-conducteur selon la revendication 1, **caractérisé en ce que** le dopant est un métal alcalin et/ou alcalinoterreux, de préférence le césium.

6. Matériau semi-conducteur selon l'une quelconque des revendications précédentes, **caractérisé en ce que** la concentration du dopant est 0,5 à 25 pourcent en masse, de préférence 1 à 10 pourcent en masse, de préférence particulière 2,5 à 5 pourcent en masse.

7. Diode électroluminescente organique qui comprend un matériau semi-conducteur selon l'une quelconque des revendications précédentes.
